# FASCICULE DE BREVET EUROPEEN

(11) **EP 1 114 574 B1**
(45) Date de publication et mention de la délivrance du brevet: **29.05.2002**
(21) Numéro de dépôt: 99942950.9
(22) Date de dépôt: 10.09.1999
(51) Int. Cl.: H05K 7/14

(54) **DISPOSITIF DE CONNEXION POUR UN ENSEMBLE DE STRUCTURES MODULAIRES PORTE-CARTES ELECTRONIQUES ET RACK EQUIPE D'UN TEL DISPOSITIF, ACCUEILLANT UN TEL ENSEMBLE**
VERBINDUNGSVORRICHTUNG FÜR EIN MODULARES ENSEMBLE ELEKTRONISHER LEITERPLATTEN UND LEITERPLATTENTRÄGER WELCHER MIT EINER SOLCHEN VORRICHTUNG AUSGERÜSTET IST
CONNECTING DEVICE FOR AN ASSEMBLY OF LINE REPLACEABLE MODULES FOR ELECTRONIC WALLETS AND RACK EQUIPPED WITH SAME FOR RECEIVING SUCH AN ASSEMBLY

(30) Priorité: 15.09.1998 FR 9811499
(43) Date de publication de la demande: 11.07.2001
(73) Titulaire: THALES AVIONICS S.A., 78141 Vélizy Villacoublay Cédex (FR)
(72) Inventeur: SARNO, Claude, Thomson-CSF Prop. Intel., 94117Arc ueil Cedex (FR); BOUTEILLE, Henri, Thomson-CSF Prop. Intel., 94117Arc ueil Cedex (FR)
(74) Mandataire: Guérin, Michel
(86) Numéro de dépôt international: FR9902161
(87) Numéro de publication internationale: WO0016599

(56) Documents cités:
- FR-A- 2 491 716
- US-A- 4 179 172
- US-A- 5 348 482

## Description

La présente invention est relative à un dispositif de connexion destiné à un ensemble de structures modulaires porte-cartes électroniques. Ces structures modulaires sont connues par la dénomination anglaise de LRM pour "Line Replaceable Module" soit "Module Remplaçable en Ligne" en langue française.

Une telle structure modulaire comporte une enveloppe contenant une ou plusieurs cartes électroniques et est équipée d'au moins un bloc de connexion, devant coopérer avec le dispositif de connexion, pour assurer une liaison entre les cartes électroniques et une installation externe avec laquelle s'établit une circulation de signaux. Le terme "carte électronique" englobe tous substrats sur lesquels on peut interconnecter des composants électroniques, tels que les circuits imprimés, les substrats en céramique, en silicium.... Les structures modulaires de l'ensemble sont habituellement regroupées dans un rack.

L'installation externe peut être, mais pas exclusivement située à bord d'un aérodyne. Dans cette application, la circulation de signaux se fait entre un ou plusieurs racks et les différents organes de l'aérodyne tels que par exemple, les volets, les gouvernes, le train d'atterrissage, les instruments de navigation, différents capteurs de pression, de température etc...

Ces signaux ne sont pas exclusivement des signaux électriques, ils peuvent être optiques par exemple. Dans les structures modulaires les signaux sont traités par les cartes électroniques. II s'établit aussi une communication entre cartes électroniques d'une même structure modulaire ou de différentes structures modulaires.

Dans les aérodynes modernes, les organes susceptibles de fournir ou de recevoir de tels signaux sont extrêmement nombreux et de plus, le concept d'avionique modulaire intégrée, qui tend à remplacer les fonctions électroniques réparties par des racks centralisés, a un effet de concentration des signaux. De ce fait, il est possible de faire arriver plusieurs milliers de conducteurs véhiculant ces signaux, à proximité des structures modulaires situées dans le rack.

Les problèmes que l'on rencontre alors sont multiples, ils se situent notamment au moment de la connexion des conducteurs aux structures modulaires mais aussi lors des interventions pour dépannage.

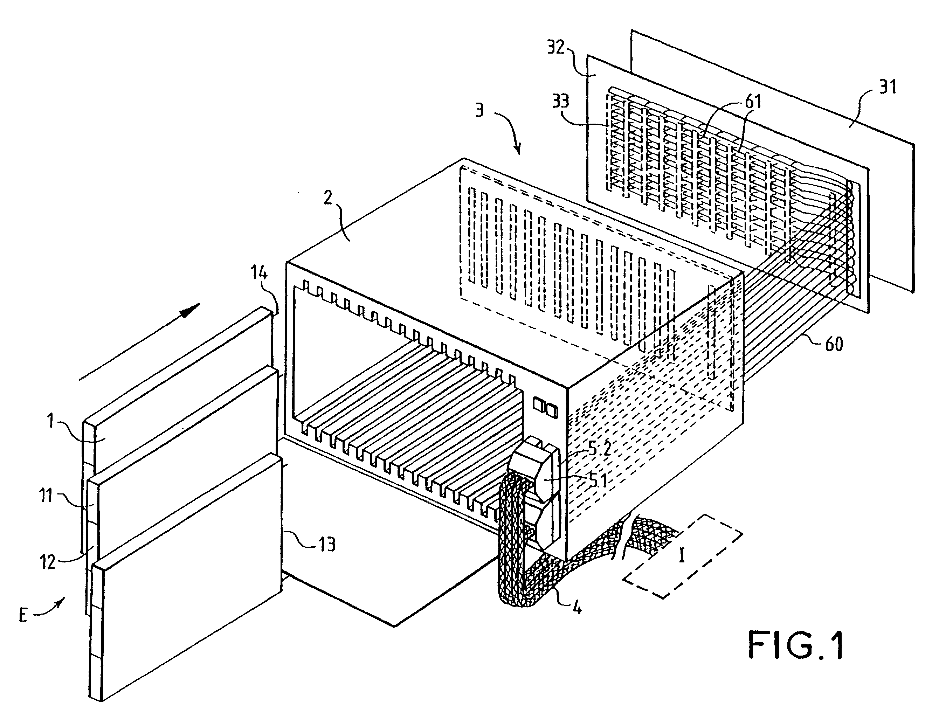

La figure 1 montre schématiquement en éclaté un dispositif de connexion d'un ensemble E de structures modulaires de type connu. Les structures modulaires 1 sont à glisser à la manière d'un tiroir dans le rack 2. De manière classique, les structures modulaires 1 se présentent sous la forme d'un boîtier logeant une ou plusieurs cartes électroniques (non visibles sur la figure 1). Leur face avant 11 comporte généralement une poignée de verrouillage 12 (schématisée) servant à l'insertion, et à l'extraction de la structure modulaire 1. Leur face arrière 13 comporte un ou plusieurs blocs de connexion 14 multi-points reliés aux cartes électroniques. Sur la figure 1 on devine la présence de tels blocs de connexion.

Le dispositif de connexion occupe le fond 3 du rack 2 et il est protégé par un couvercle 31 qui se fixe au rack 2. Le dispositif de connexion comporte au moins un circuit 32 dit de fond panier, imprimé ou souple, équipé de blocs de connexion 33 qui émergent vers les blocs de connexion 14 des structures modulaires 1 lorsque le circuit est en place. Ces blocs de connexion 33 sont destinés à s'accoupler à ceux des structures modulaires 1.

Des faisceaux de conducteurs 4 arrivent en face avant du rack 2, ils proviennent des différents organes de l'installation externe I schématisée par un rectangle en pointillés. Ces conducteurs 4 aboutissent sur un ou plusieurs blocs de connexion 5.1 qui se branchent, depuis la face avant du rack 2 sur d'autres blocs de connexion 5.2. L'ensemble des conducteurs 4 et des blocs de connexions 5.1, 5.2 accaparent une grande place non utilisable par l'électronique. Entre ces blocs de connexions 5.1, 5.2 et les blocs de connexion 33 prend place un réseau très dense de premiers conducteurs 60 qui assurent une liaison avec le circuit 32 fond de panier.

Le circuit 32 de fond de panier accueille, de plus, des seconds conducteurs 61 qui relient entre eux des blocs de connexion 33, lorsqu'une circulation de signaux entre des cartes électroniques appartenant à différentes structures modulaires 1 est requise.

Ce type d'architecture connectique n'est pas aisé à concevoir car la densité des conducteurs 4, 61, 60 est importante. Sur la figure 1 les milliers de conducteurs n'ont pu être représentés. Entre les connecteurs 5.1, 5.2 et le circuit 32 de fond de panier les premiers conducteurs 60 constituent un goulot d'étranglement difficile à implémenter. En cas de panne, la localisation de celle-ci et sa réparation ne sont pas aisées.

Le circuit 32 fond de panier est spécifique au rack 2 et un autre agencement des structures modulaires 1 dans le rack 2 n'est pas envisageable sans changer de circuit 32 fond de panier. De plus, les faisceaux de conducteurs 4 peuvent constituer une gêne lors de leur renvoi vers l'installation externe I en courant sur le côté, le dessus ou le dessous du rack 2 alors que bien souvent cette place pourrait servir à accoler d'autres racks 2.

La présente invention vise notamment à résoudre ces problèmes de connexion, de maintenance, d'encombrement.

Pour y parvenir le dispositif de connexion selon l'invention comporte, à proximité de l'ensemble de structures modulaires :
- une platine pourvue d'ouvertures,
- des blocs de connexion terminaux provenant de l'installation externe, devant s'insérer dans les ouvertures et s'accoupler directement chacun à un bloc de connexion porté par l'une des structures modulaires et,
solidaire de la platine, un circuit de distribution de signaux entre structures modulaires, protégé de l'environnement ambiant.

La protection vis-à-vis de l'environnement ambiant peut se faire par un capot qui coiffe au moins le circuit de distribution de signaux alors placé entre la platine et le capot.

Le circuit de distribution de signaux peut être café entre la platine et le capot par respectivement au moins une première entretoise et une seconde entretoise.

Le circuit de distribution de signaux peut comporter au moins une terminaison conductrice coopérant avec un bloc de connexion de premier type devant s'accoupler directement à un bloc de connexion porté par une structure modulaire de l'ensemble, ce bloc de connexion de premier type devant s'insérer dans une ouverture de la platine.

Lorsqu'une communication avec au moins une structure modulaire extérieure à l'ensemble est requise, le circuit de distribution de signaux comporte au moins une terminaison conductrice, coopérant avec un bloc de connexion de second type menant à la structure modulaire extérieure à l'ensemble.

Le bloc de connexion de second type est insérable dans une ouverture du capot.

Le capot peut être métallique ou métallisé pour assurer une protection contre des perturbations électromagnétiques du circuit de distribution de signaux.

Les blocs de connexion terminaux sont solidarisables de la platine pour garantir la fiabilité des connexions électriques et mécaniques et contribuer à la continuité de masse électrique.

De la même manière, le bloc de connexion de second type peut être solidarisable au capot.

Pour éviter des erreurs de connexion au montage, il est préférable que les ouvertures de la platine et les blocs de connexion terminaux soient équipés de moyens de détrompage.

Surtout si le bloc de connexion de second type est similaire aux blocs de connexion terminaux, il est préférable que l'ouverture du capot et le bloc de connexion de second type soient équipés de moyens de détrompage.

La présente invention concerne aussi un rack destiné à contenir un ensemble de structures modulaires porte-cartes électroniques destiné à coopérer avec un dispositif de connexion selon l'invention. Ce rack possède des faces parmi lesquelles une qui sert de fond, le fond recevant la platine du dispositif de connexion.

Pour pouvoir assembler plusieurs racks sans être gêné par des moyens d'assemblage proéminents, au moins une des faces du rack comporte au moins une zone d'assemblage extérieure en creux, cette zone devant accueillir les moyens d'assemblage qui restent en retrait ou affleurent la face après l'assemblage.

Une ou plusieurs de ses faces sont équipées d'au moins un orifice pour refroidir les structures modulaires .

S'il doit accueillir un grand nombre de structures modulaires, il est préférable qu'il contienne au moins une cloison de rigidification délimitant au moins deux logements pour les structures modulaires (1).

D'autres caractéristiques et avantages de l'invention apparaîtront à la lecture de la description d'exemples de réalisation de dispositifs de connexion et de rack selon l'invention, la description étant illustrée par les figures qui représentent:
- la figure 1, déjà décrite, une vue en éclaté d'un rack accueillant un ensemble de structures modulaires coopérant avec un dispositif de connexion connu ;
- les figures 2a, 2b, 2c respectivement une vue de face, de dos et une coupe d'un dispositif de connexion selon l'invention ;
- la figure 2d une platine du dispositif de connexion illustré aux figures 2a à 2c, sans les blocs de connexion terminaux, ni le circuit de distribution de signaux ;
- la figure 3 une coupe longitudinale du circuit de distribution de signaux d'un dispositif de connexion selon l'invention ;
- la figure 4 une vue en éclaté de deux racks selon l'invention prêts à être assemblés l'un à l'autre.

Sur ces figures les mêmes éléments portent la même référence et les échelles ne sont pas forcément respectées dans un souci de clarté.

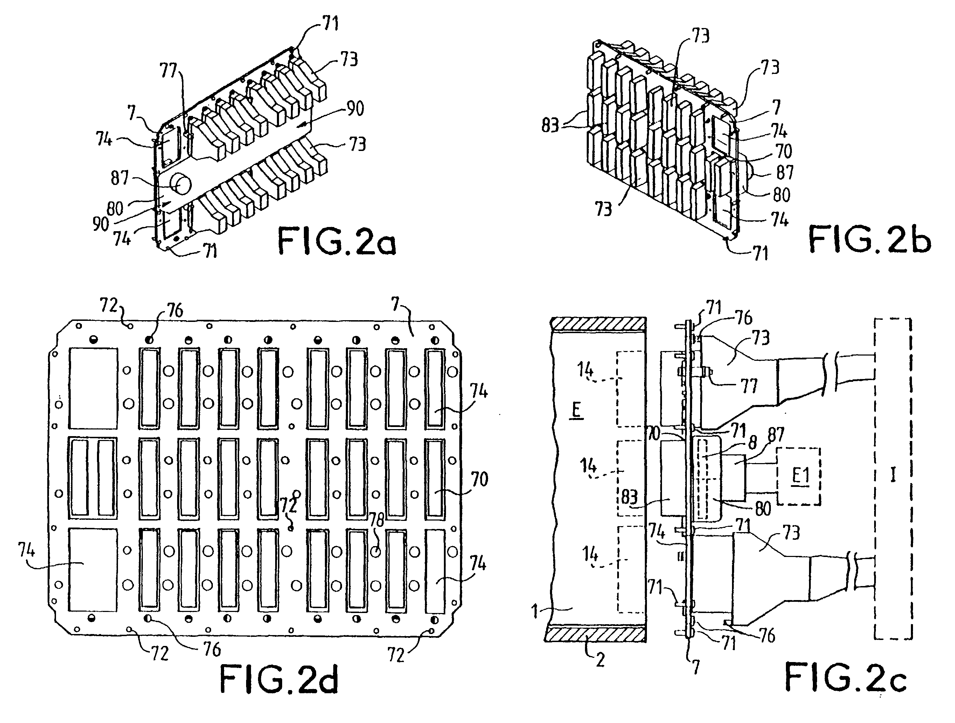

On se réfère maintenant aux figures 2.

Le dispositif de connexion selon l'invention comporte une platine 7 ajourée qui peut être fixée au fond d'un rack destiné à accueillir un ensemble E de structures modulaires 1, similaire à celui représenté à la figure 1. Sur la figure 2c le rack 2 n'est vu qu'en coupe.

Le dispositif de connexion pourrait coopérer avec un ensemble de structures modulaires sans que ces dernières ne soient regroupées dans un rack fermé, il pourrait être réduit à un simple chassis de maintien solidaire de la platine 7. Dans tous les cas la platine se trouverait à proximité de l'ensemble E des structures modulaires 1.

On suppose, dans l'exemple décrit, que la platine 7 est fixée au rack 2 par des vis 71 qui passent à travers de trous 72 répartis sur son pourtour. Selon une caractéristique de l'invention, la platine 7 comporte des ouvertures 74 destinées à supporter des blocs de connexion 73 terminaux d'une installation externe l avec laquelle les structures modulaires 1 sont destinées à communiquer. Les blocs de connexion 73 terminaux sont destinés à s'accoupler directement avec des blocs de connexion 14 portés par les structures modulaires 1 de l'ensemble E, ce qui forme les deux parties d'un connecteur. Les blocs de connexion 14 des structures modulaires 1, visibles en pointillés sur la figure 2c, sont placés dans des logements appropriés des structures modulaires 1.

Les blocs de connexion 73 terminaux de l'installation externe I et ceux 14 appartenant aux structures modulaires 1 peuvent être tout à fait standards que ce soit des blocs de connexion avec une pluralité de contacts électriques, des blocs de connexion dont les contacts sont plus complexes tels que des coaxiaux ou des blocs de connexion réalisant des connexions optiques, ou de tout autres types.

Ces blocs de connexion 73 terminaux peuvent être blindés au point de vue électromagnétique et/ou étanches à l'humidité s'ils sont susceptibles d'être soumis à un environnement hostile, humide, satin.....

Les blocs de connexion 73 terminaux de l'installation externe I viennent s'insérer dans les ouvertures 74 de la platine 7. Ils sont équipés d'un dispositif de détrompage 76. Le dispositif de détrompage 76 peut être de type classique, par exemple comporter une clef à pans coupés solidaire du bloc de connexion 73 terminal, s'insérant dans une ouverture positionnable et complémentaire portée par la platine 7.

Chaque bloc 73 de connexion terminal est solidarisable dans une ouverture 7. de la platine 7, à cet effet il comporte des moyens de maintien 77 dans l'ouverture de la platine 7. Ces moyens de maintien peuvent être des vis 77 par exemple, et la platine 7 comporte alors des trous dans lesquels viennent se ficher ces vis 77. De tels moyens de maintien garantissent la fiabilité des connexions mécaniques, électriques et contribuent à la continuité de masse électrique.

Sur la figure 2d, on voit sur la gauche des ouvertures 74 de surface plus grande que celle des ouvertures 74 situées à droite. Les blocs 73 de connexion terminaux auront plus ou moins de points de connexion selon les besoins et notamment selon les tailles des structures modulaires 1. On peut aussi envisager qu'une grande ouverture 74 accueille plusieurs blocs 73 de connexion.

Le dispositif de connexion comporte aussi, solidaire de la platine 7, un circuit 8 de distribution de signaux entre structures modulaires 1. Ce circuit 8 de distribution de signaux est protégé de l'environnement ambiant.

Le circuit 8 de distribution de signaux n'est pas visible sur les figures 2a, 2b, car la protection contre l'environnement ambiant est un capot 80, représenté en place et il le masque. II est schématisé en pointillés sur la figure 2c.

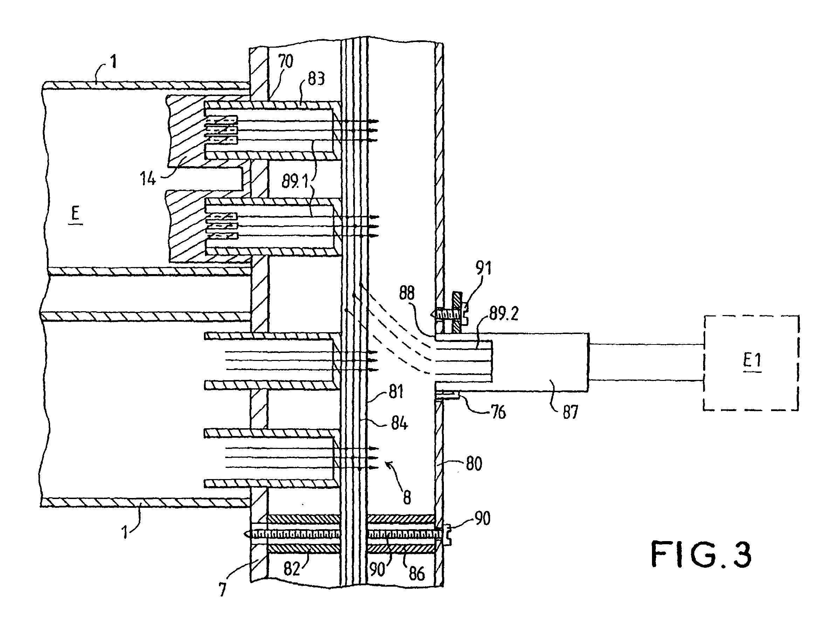

La figure 3 montre de manière plus détaillée le circuit 8 de distribution de signaux en coupe vue de dessus.

Le circuit 8 de distribution de signaux est formé d'au moins un conducteur 84 pour acheminer des signaux d'une structure modulaire à une autre. Sur la figure, le conducteur 84 est situé sur une couche d'un circuit imprimé 81 multicouche qui fait face à la platine 7 et qui est rapporté sur celle-ci à l'opposé des structures modulaires 1, à une certaine distance de celle-ci par au moins une première entretoise 82.

On peut imaginer que le circuit de distribution 8 de signaux ne comporte pas de circuit imprimé, par exemple, si les conducteurs 84 sont filaires ou de type optique.

Le circuit 8 de distribution de signaux comporte au moins une terminaison 89.1 conductrice coopérant avec un bloc 83 de connexion de premier type destiné à s'accoupler directement à un bloc de connexion 14 d'une des structures modulaires 1 de l'ensemble E.

Le bloc de connexion 83 de premier type passe à travers une ouverture 70 de la platine 7. Le bloc de connexion de premier type 83 peut être tout à fait standard et similaire au bloc de connexion terminal 73 et le nombre de points de connexion qu'il possède est adapté aux besoins.

Dans le cas d'une liaison électrique entre le bloc de connexion 83 de premier type et le circuit de distribution 8 en circuit imprimé, la terminaison conductrice 89.1 peut être un contact mâle issu du bloc de connexion de premier type 83. Elle est intégrée au bloc de connexion 83 de premier type et peut être rapportée par soudure, par exemple, sur le conducteur 84 du circuit imprimé. Cette description n'est pas limitative, d'autres configurations sont envisageables.

Le circuit de distribution 8 est solidaire de la platine 7 par des vis 90 par exemple, pour éviter tout risque de déconnexion. Le capot 80 de protection recouvre au moins le circuit imprimé 81. On pourrait envisager qu'il couvre aussi les blocs de connexion terminaux 73. II est maintenu en position par rapport au circuit de distribution de signaux 8 par des secondes entretoises 86 et est solidaire soit de celui-ci, soit de la platine 7. Dans l'exemple décrit les mêmes vis 90 servent au maintien du capot 80, du circuit de distribution 8 et de la platine 7.

De préférence, le capot 80 est métallique ou métallisé de manière à assurer une protection du circuit 8 de distribution de signaux vis-à-vis de perturbations électromagnétiques.

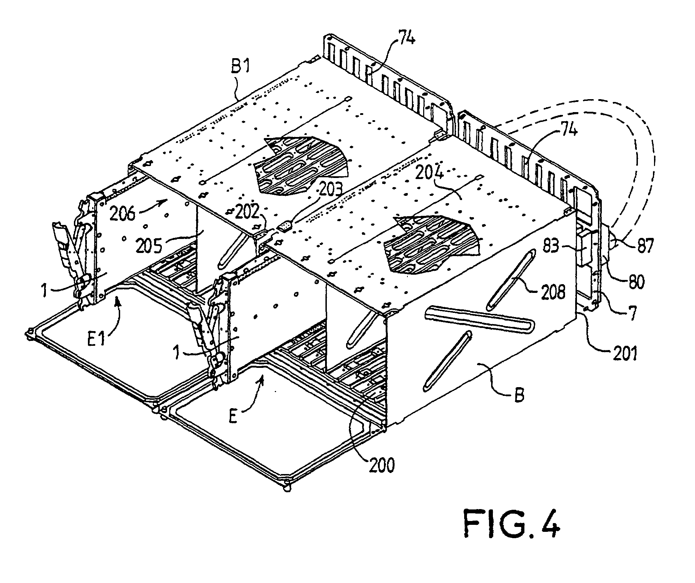

Lorsqu'une communication avec au moins une structure modulaire extérieure à l'ensemble E est requise, le circuit de distribution de signaux 8 comporte au moins une terminaison 89.2 conductrice, coopérant avec un bloc de connexion 87 de second type menant à la structure modulaire extérieure à l'ensemble E. Sur les figures 2c et 3, on a supposé que la communication se faisait avec une structure modulaire (non visible) appartenant à un second ensemble E1. Sur la figure 4, les ensembles E, E1 de structures modulaires sont logés dans des racks différents respectivement référencés B, B1.

Ce bloc de connexion de second type 87 traverse une ouverture 88 du capot 80. II comporte des moyens de maintien 91 au capot tels que des vis par exemple. Sur la figure 3, la terminaison conductrice 89.2 est reliée à au moins un conducteur 84 du circuit de distribution 8 de signaux. Le bloc de connexion 87 de second type peut être standard ou similaire aux blocs de connexion 73 terminaux.

Les blocs de connexion 87 de second type peuvent être équipés de moyens de détrompage 76 notamment lorsqu'ils sont similaires aux blocs de connexion terminaux 73, ces moyens de détrompage 76 peuvent être similaires à ceux associés aux blocs de connexion terminaux. Les moyens de détrompage 76 ont été schématisés sur la figure 3. Des erreurs au montage sont ainsi évitées.

La présente invention concerne aussi un rack B, B1 destiné à recevoir un ensemble E, E1 de structures modulaires 1 (une seule structure modulaire 1 est représentée dans chaque ensemble pour ne pas surcharger la figure) et à coopérer avec un dispositif de connexion selon l'invention. La figure 4 montre deux racks B, B1 selon l'invention prêts à être assemblés l'un à l'autre. Ils se présentent sous la forme d'une structure mécanique sensiblement parallélipipédique avec une face avant 200 qui reçoit une porte et une face arrière 201 opposée à la face avant 200 qui sert de fond, ce dernier reçoit la platine 7 du dispositif de connexion selon l'invention. Si le besoin s'en fait sentir les racks B, B1 peuvent posséder, sur au moins une de leur face, au moins un orifice 208 permettant un refroidissement par circulation d'air des structures modulaires 1. Sur la figure 4, les orifices sont référencés sur une face latérale 204.

Pour pouvoir assembler les deux racks B, B1 sans être gêné par des moyens d'assemblage 203 proéminents, chacun d'entre eux comporte sur au moins une de ses faces 204, à l'extérieur, au moins une zone d'assemblage 202 configurée en creux pour y loger les moyens d'assemblage 203. Lorsque l'assemblage est réalisé, les moyens d'assemblage 203 restent en retrait ou affleurent la face 204.

Sur la figure 4, les moyens d'assemblage 203 sont en forme de patte dont une extrémité est fixée au premier rack B et dont l'autre extrémité au second rack B1, ces fixations se faisant par vissage par exemple.

On peut prévoir, surtout si les racks sont destinés à recevoir un grand nombre de structures modulaires 1 qu'ils contiennent au moins une cloison 205 de séparation intérieure, délimitant au moins deux logements 206 pour les structures modulaires 1. Ces cloisons 205 ont une fonction de rigidification, elles peuvent aussi avoir une fonction de ségrégation au feu, à l'explosion ......

Maintenant les structures modulaires 1, peuvent occuper pratiquement tout le volume intérieur du rack B, B1. L'encombrement du dispositif de connexion n'est plus un inconvénient puisqu'il est relégué à l'arrière des structures modulaires. Par rapport à des structures modulaires qui étaient reliées à l'installation externe par plusieurs niveaux de circuits de fond de panier, on a gagné de la surface utile sur les cartes en profondeur.

Sur la platine 7, les surfaces occupées par le circuit de distribution de signaux 8 et par les blocs de connexion terminaux 73 sont tout à fait adaptables aux besoins, les ouvertures pouvant recevoir les blocs de connexions quels que soient leur type.

Tous les blocs de connexion pouvant être standards, leur changement en cas de panne n'est pas un problème et le coût est réduit.

Le montage des blocs de connexion terminaux de l'installation I est particulièrement simple et l'interchangeabilité facilite le remplacement d'une structure modulaire par une autre.

Le dispositif de connexion selon l'invention permet d'interchanger deux structures modulaires de même taille sans conséquence sur le cablage. On a aussi gagné en fiabilité de connexion puisque il n'y a plus qu'une liaison connectique entre les cartes électroniques et l'installation externe. Un gain en masse et en coût a aussi été obtenu par la simplification.

## Revendications

1. Dispositif de connexion d'un ensemble (E) de structures modulaires (1) porte-cartes électroniques à une installation externe (I) avec laquelle s'établit une circulation de signaux, ce dispositif de connexion assurant également une communication entre différentes structures modulaires (1), **caractérisé en ce qu'**il comporte à proximité de l'ensemble (E) de structures modulaires (1),
- une platine (7) pourvue d'ouvertures (74, 70),
- des blocs de connexion (73) terminaux provenant de l'installation (I), chaque bloc de connexion (73) terminal devant s'insérer dans une ouverture (74) qui le supporte et devant s'accoupler directement à un bloc de connexion (14) porté par une structure modulaire (1) de l'ensemble (E) et, de plus
- solidaire de la platine (7), un circuit de distribution (8) de signaux entre différentes structures modulaires (1), protégé de l'environnement ambiant, relié à au moins un bloc de connexion (83) de premier type devant s'accoupler directement à un bloc (14) porté par une structure modulaire (1) de l'ensemble (E), ce bloc de connexion (83) de premier type devant s'insérer dans une ouverture (70) de la platine (7), les ouvertures (70, 74) pouvant recevoir les blocs de connexion quels que soient leurs types.

2. Dispositif de connexion selon la revendication 1, **caractérisé en ce qu'**un capot (80) de protection coiffe au moins le circuit (8) de distribution de signaux placé entre la platine (7) et le capot (80).

3. Dispositif de connexion selon la revendication 2, **caractérisé en ce que** le circuit (8) de distribution de signaux est calé entre la platine (7) et le capot (81) par respectivement au moins une première entretoise (82) et au moins une seconde entretoise (86).

4. Dispositif de connexion selon l'une des revendications 1 à 3, **caractérisé en ce que** le circuit (8) de distribution de signaux comporte au moins une terminaison (89.1) conductrice coopérant avec un bloc de connexion (83) de premier type.

5. Dispositif de connexion selon l'une des revendications 1 à 4, **caractérisé en ce que**, lorsqu'une communication avec au moins une structure modulaire extérieure à l'ensemble (E) est requise, le circuit de distribution de signaux (8) comporte au moins une terminaison (89.2) conductrice, coopérant avec un bloc de connexion (87) de second type menant à la structure modulaire extérieure à l'ensemble (E).

6. Dispositif de connexion selon la revendication 5, **caractérisé en ce que** le bloc de connexion (87) de second type est insérable dans une ouverture (88) portée par le capot (80).

7. Dispositif de connexion selon l'une des revendications 2 à 6, **caractérisé en ce que** le capot (80) assure une protection contre des perturbations électromagnétiques au circuit de distribution de signaux (8).

8. Dispositif de connexion selon l'une des revendications 1 à 7, **caractérisé en ce que** les blocs de connexion terminaux (73) sont solidarisables de la platine (7).

9. Dispositif de connexion selon l'une des revendications 5 à 8, **caractérisé en ce que** le bloc de connexion (87) de second type est solidarisable du capot (80).

10. Dispositif de connexion selon l'une des revendications 1 à 9, **caractérisé en ce que** les ouvertures (74) de la platine (7) et les blocs de connexion terminaux (73) sont équipés de moyens de détrompage (76).

11. Dispositif de connexion selon l'une des revendications 5 à 10, **caractérisé en ce que** l'ouverture du capot (80) et le bloc de connexion (87) de second type sont équipés de moyens de détrompage (76).

12. Rack (B1, B2) destiné à contenir un ensemble (E) de structures modulaires (1) porte-cartes électroniques ayant des faces (202, 204) parmi lesquelles une servant de fond (202), ce rack étant destiné à coopérer avec un dispositif de connexion selon l'une des revendications 1 à 11, **caractérisé en ce que** le fond (202) reçoit la platine (7) du dispositif de connexion.

13. Rack selon la revendication 12, **caractérisé en ce qu'**il comporte sur au moins l'une de ses faces (204), à l'extérieur, au moins une zone (202) d'assemblage en creux par rapport à la face, cette zone (202) devant accueillir des moyens d'assemblage (203) lors d'un assemblage avec un autre rack (B2), les moyens d'assemblage (203) restant en retrait ou affleurant la face (204) après l'assemblage.

14. Rack selon l'une des revendications 12 ou 13, **caractérisé en ce qu'**une ou plusieurs de ses faces sont équipées d'au moins un orifice (208) pour refroidir les structures modulaires .

15. Rack selon l'une des revendications 12 à 14, **caractérisé en ce qu'**il contient au moins une cloison (205) de rigidification délimitant au moins deux logements (206) pour les structures modulaires (1).

## Claims

1. Device for connecting an array (E) of electronic-card-carrying modular structures (1) to an external installation (I) with which a flow of signals can be established, this connection device also providing communication between various modular structures (1), **characterized in that** it comprises, near the array (E) of modular structures (1),
- a plate (7) provided with openings (74, 70),
- terminal connection blocks (73) coming from the installation (I), each terminal connection block (73) having to be inserted into an opening (74) which bears it and having to be coupled directly to a connection block (14) carried by a modular structure (1) of the array (E) and, additionally,
- fastened to the plate (7), a circuit (8) for distributing signals between various modular structures (1), which is protected from the ambient environment, and is connected to at least one first-type connection block (83) that has to be directly coupled to a block (14) carried by a modular structure (1) of the array (E), this first-type connection block (83) having to be inserted into an opening (70) in the plate (7), the openings (70, 74) being able to accommodate the connection blocks whatever their type.

2. Connection device according to Claim 1, **characterized in that** a protective cap (80) covers at least the signal distribution circuit (8) placed between the plate (7) and the cap (80).

3. Connection device according to Claim 2, **characterized in that** the signal distribution circuit (8) is immobilized between the plate (7) and the cap (80) by at least one first spacer (82) and at least one second spacer (86), respectively.

4. Connection device according to one of Claims 1 to 3, **characterized in that** the signal distribution circuit (8) includes at least one conducting termination (89.1) cooperating with a first-type connection block (83).

5. Connection device according to one of Claims 1 to 4, **characterized in that**, when communication with at least one modular structure external to the array (E) is required, the signal distribution circuit (8) includes at least one conducting termination (89.2) cooperating with a second-type connection block (87) leading to the modular structure external to the array (E).

6. Connection device according to Claim 5, **characterized in that** the second-type connection block (87) can be inserted into an opening (88) in the cap (80).

7. Connection device according to one of Claims 2 to 6, **characterized in that** the cap (80) protects the signal distribution circuit (8) against electromagnetic interference.

8. Connection device according to one of Claims 1 to 7, **characterized in that** the terminal connection blocks (73) can be fastened to the plate (7).

9. Connection device according to one of Claims 5 to 8, **characterized in that** the second-type connection block (87) can be fastened to the cap (80).

10. Connection device according to one of Claims 1 to 9, **characterized in that** the openings (74) in the plate (7) and the terminal connection blocks (73) are provided with polarization means (76).

11. Connection device according to one of Claims 5 to 10, **characterized in that** the opening in the cap (80) and the second-type connection block (87) are provided with polarization means (76).

12. Rack (B1, B2) intended to contain an array (E) of electronic-card-carrying modular structures (1) having faces (202, 204) among which one serves as the back (202), this rack being intended to cooperate with a connection device according to one of Claims 1 to 11, **characterized in that** the back (202) houses the plate (7) of the connection device.

13. Rack according to Claim 12, **characterized in that** it includes, on at least one of its faces (204), on the outside, at least one assembly region (202) recessed with respect to the face, this region (202) having to accommodate assembly means (203) when joining it to another rack (B2), the assembly means (203) remaining set back or flush with the face (204) after the assembly operation.

14. Rack according to either of Claims 12 and 13, **characterized in that** one or more of its faces are provided with at least one orifice (208) for cooling the modular structures.

15. Rack according to one of Claims 12 to 14, **characterized in that** it contains at least one stiffening partition (205) defining at least two housings (206) for the modular structures (1).

## Patentansprüche

1. Vorrichtung zum Verbinden einer Gruppe (E) modularer Strukturen aus Trägern elektronischer Karten mit einer externen Anlage (I), mit der ein Signalfluß hergestellt wird, wobei diese Verbindungsvorrichtung außerdem eine Kommunikation zwischen verschiedenen modularen Strukturen (1) sicherstellt, **dadurch gekennzeichnet, daß** sie in der Umgebung der Gruppe (E) modularer Strukturen (1) versehen ist mit
- einer mit Öffnungen (74, 70) versehenen Platine (7),
- Anschlußverbindungsblöcken (73), die von der Anlage (I) ausgehen, wobei jeder Anschlußverbindungsblock (73) in eine ihn haltende Öffnung (74) eingeschoben und direkt mit einem Verbindungsblock (14), der durch eine modulare Struktur (1) der Gruppe (E) gehalten wird, verbunden werden muß, und darüber hinaus
- einer mit der Platine (7) einteilig ausgebildeten Schaltung (8) zur Verteilung von Signalen zwischen verschiedenen modularen Strukturen (1), die vor der Umgebung geschützt ist und mit wenigstens einem Verbindungsblock (83) eines ersten Typs, der direkt mit einem von der modularen Struktur (1) der Gruppe (E) getragenen Block (14) gekoppelt werden muß, verbunden ist, wobei dieser Verbindungsblock (83) des ersten Typs in eine Öffnung (70) der Platine (7) eingeschoben werden muß, wobei die Öffnungen (70, 74) Verbindungsblöcke beliebigen Typs aufnehmen können.

2. Verbindungsvorrichtung nach Anspruch 1, **dadurch gekennzeichnet, daß** eine Schutzhaube (80) wenigstens die zwischen der Platine (7) und der Haube (80) angeordnete Signalverteilungsschaltung (8) bedeckt.

3. Verbindungsvorrichtung nach Anspruch 2, **dadurch gekennzeichnet, daß** die Signalverteilungsschaltung (8) zwischen die Platine (7) und die Haube (81) wenigstens mittels eines ersten Abstandshalters (82) und wenigstens eines zweiten Abstandshalters (86) eingefügt ist.

4. Verbindungsvorrichtung nach einem der Ansprüche I bis 3, **dadurch gekennzeichnet, daß** die Signalverteilungsschaltung (8) wenigstens einen leitenden Endpunkt (89.1), der mit einem Verbindungsblock (83) des ersten Typs zusammenwirkt, umfaßt.

5. Verbindungsvorrichtung nach einem der Ansprüche 1 bis 4, **dadurch gekennzeichnet, daß** die Signalverteilungsschaltung (8) dann, wenn eine Kommunikation mit wenigstens einer modularen Struktur außerhalb der Gruppe (E) erforderlich ist, wenigstens einen leitenden Endpunkt (89.2) umfaßt, der mit einem Verbindungsblock (87) des zweiten Typs zusammenwirkt, der zur modularen Struktur außerhalb der Gruppe (E) führt

6. Verbindungsvorrichtung nach Anspruch 5, **dadurch gekennzeichnet, daß** der Verbindungsblock (87) des zweiten Typs in eine Öffnung (88) der Haube (80) einschiebbar ist.

7. Verbindungsvorrichtung nach einem der Ansprüche 2 bis 6, **dadurch gekennzeichnet, daß** die Haube (80) einen Schutz gegen elektromagnetische Störungen der Signalverteilungsschaltung (8) gewährleistet.

8. Verbindungsvorrichtung nach einem der Ansprüche 1 bis 7, **dadurch gekennzeichnet, daß** die Anschlußverbindungsblöcke (73) mit der Platine (7) einteilig ausgebildet werden können.

9. Verbindungsvorrichtung nach einem der Ansprüche 5 bis 8, **dadurch gekennzeichnet, daß** der Verbindungsblock (87) des zweiten Typs mit der Haube (80) einteilig ausgebildet werden kann.

10. Verbindungsvorrichtung nach einem der Ansprüche 1 bis 9, **dadurch gekennzeichnet, daß** die Öffnungen (74) der Platine (7) und die Anschlußverbindungsblöcke (73) mit Unverechselbarkeitsmitteln (76) versehen sind.

11. Verbindungsvorrichtung nach einem der Ansprüche 5 bis 10, **dadurch gekennzeichnet, daß** die Öffnung der Haube (80) und der Anschlußblock (87) des zweiten Typs mit Unverwechselbarkeitsmitteln (76) versehen sind.

12. Einschubgehäuse (B1, B2), das dazu bestimmt ist, eine Gruppe (E) modularer Strukturen (1) aus Trägern elektronischer Karten aufzunehmen, und Flächen (202, 204) besitzt, wovon eine als Boden (202) dient, wobei dieses Einschubgehäuse dazu bestimmt ist, mit einer Verbindungsvorrichtung nach einem der Ansprüche 1 bis 11 zusammenzuwirken, **dadurch gekennzeichnet, daß** der Boden (202) die Platine (7) der Verbindungsvorrichtung aufnimmt

13. Einschubgehäuse nach Anspruch 12, **dadurch gekennzeichnet, daß** es auf wenigstens einer ihrer Flächen (204) an der Außenseite wenigstens eine Zone (202) für eine eingebettete Montage in bezug auf diese Fläche umfaßt, wobei diese Zone (202) Montagemittel (203) aufnehmen muß, wenn ein weiteres Einschubgehäuse (B2) angebracht wird, wobei die Montagemittel (203) nach der Montage in bezug auf die Fläche (204) zurückgesetzt oder mit dieser bündig sind.

14. Einschubgehäuse nach einem der Ansprüche 12 oder 13, **dadurch gekennzeichnet, daß** eine oder mehrere seiner Flächen mit wenigstens einer Öffnung (208) für die Kühlung der modularen Strukturen versehen sind.

15. Einschubgehäuse nach einem der Ansprüche 12 bis 14, **dadurch gekennzeichnet, daß** es wenigstens eine Versteifungstrennwand (205) enthält, die wenigstens zwei Aufnahmeräume (206) für die modularen Strukturen (1) begrenzt.
